# EUROPEAN PATENT APPLICATION

(11) **EP 1 577 991 A1**
(43) Date of publication of application: **21.09.2005**
(21) Application number: 03777411.4
(22) Date of filing: 09.12.2003
(51) Int. Cl.: H01S 3/105

(54) **LASER DEVICE AND WAVELENGTH SELECTING METHOD IN LASER DEVICE**

(30) Priority: 10.12.2002 JP 2002357900
(71) Applicant: RIKEN, Saitama 351-0198 (JP); MegaOpto Co., Ltd., Saitama, 351-0114 (JP)
(72) Inventor: AKAGAWA, Kazuyuki, c/o MEGAOPTO CO., LTD., Wako-shi, Saitama 351-0114 (JP); WADA, Satoshi, c/o RIKEN, Wako-shi, Saitama 351-0198 (JP)
(74) Representative: Grünecker, Kinkeldey, Stockmair & Schwanhäusser Anwaltssozietät
(86) International application number: PCT/JP2003/015742
(87) International publication number: WO 2004/054052

(57) **Abstract**

A stable wavelength selecting action is realized by controlling a laser wavelength to permit a fast wavelength sweeping without mechanically turning a heavy-mass member. A laser device comprising a laser resonator including a mirror (12) having a specified transparency and an adaptive optics (10) provided with a mirror capable of controlling the reflection angle and wavefront of a reflection light and allowing an incident light to reflect by applying an active change to it, a laser medium (14) disposed inside the laser resonator, and a dispersion element (16) for receiving an output light from the laser medium.

## Description

### Technical Field

The present invention relates to a laser device and a wavelength selecting method in the laser device, more specifically to a laser device capable of controlling laser oscillation wavelength in high-speed and highly reliably and a wavelength selecting method in the laser device.

### Background Art

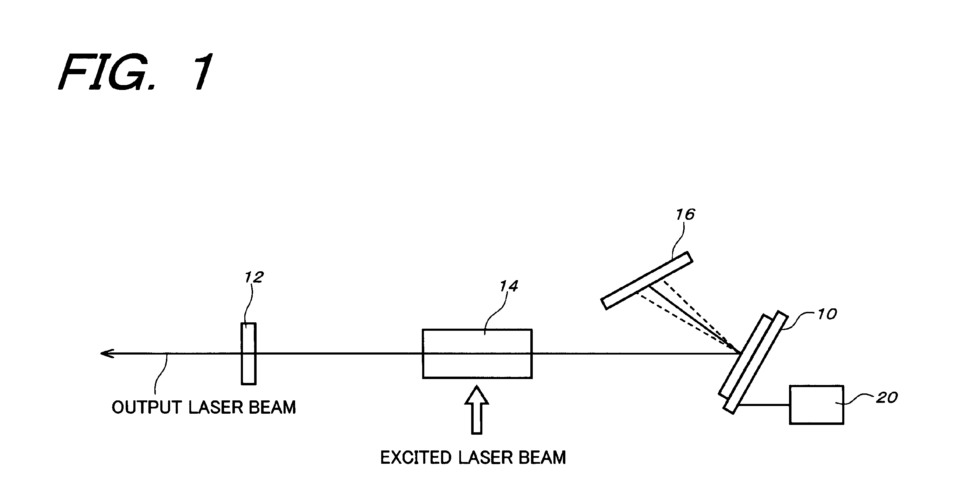

Conventionally, as a wavelength selecting method for allowing a wavelength variable laser to cause laser oscillation at a desired wavelength, there has been known a wavelength selecting method (For example, refer to Japanese Patent Laid-open Publication No.7-263779 (Fig. 1 to Fig. 3)), where elements such as a grating (diffraction grating), a birefringent filter and a prism are disposed inside a laser resonator that houses a laser medium, or a galvanometer mirror is disposed together with the elements, a precision rotation mount is rotated manually or by a motor to mechanically turn the elements such as the grating (diffraction grating), the birefringent filter and the prism or the galvanometer mirror, only output light having a desired wavelength is taken out from output light that is output from the laser medium, the output light that has been taken out is allowed to reflect toward the laser medium for amplification to generate laser oscillation, and only a laser beam having a desired wavelength is output from the laser resonator.

However, when the above-described conventional wavelength selecting method is used, the precision rotation mount is turned manually or by the motor in order to mechanically turn the elements themselves such as the grating, the birefringent filter and the prism disposed inside the laser resonator, the rotation speed of the elements was limited. Further, when the galvanometer mirror is mechanically turned, it could only be turned at about several hundred Hz at the fastest although it depends on a controlling angle. As described, the prior art had a problem that it was difficult to make wavelength variable speed faster.

Furthermore, in the above-described conventional wavelength selecting method, since the elements such as the grating, the birefringent filter and the prism or the galvanometer mirror are mechanically turned, there has been a problem that rotation of the heavy-mass member caused fluctuation and accuracy of wavelength selection was not good.

Moreover, when the precision rotation mount is used in the conventional wavelength selecting method, there is a danger that an angle cannot be accurately controlled due to backlash of a gear, and there has been a problem that wavelength reproduction accuracy was not good.

The present invention has been created in view of the various problems that the above-described prior art has, and it is an object of the present invention to provide a laser device and a wavelength selecting method in the laser device, where a laser wavelength is controlled to permit a fast wavelength sweeping without mechanically turning a heavy-mass member to realize a stable wavelength selecting action.

### Disclosure of the Invention

To achieve the above-described object, a laser device and a wavelength selecting method in the laser device in the present invention has been created from a totally different viewpoint from a conventional method where the elements such as the grating, the birefringent filter and the prism or a heavy-mass member such as the galvanometer mirror are mechanically turned.

Specifically, in the present invention, attention was focused on the point that an adaptive optics is capable of reflecting an incident light by actually applying changes to the light such as capability of controlling the reflection angle and wavefront of a reflection light, and the adaptive optics is used in the laser device.

Therefore, to achieve the above-described object, the present invention has a laser resonator made up of a mirror having predetermined transparency and an adaptive optics, a laser medium disposed inside the laser resonator, and a dispersion element for receiving an output light from the laser medium.

Further, the present invention has a laser medium capable of performing laser oscillation in a predetermined range of a wavelength band, which is disposed inside the laser resonator, an adaptive optics having a mirror for receiving an output light from the laser medium, a grating for receiving a light reflected by the mirror of the adaptive optics, and a mirror having a predetermined transparency, which is disposed for receiving a diffraction light from the grading after the light is reflected by the mirror of the adaptive optics.

Further, the present invention has a laser medium capable of performing laser oscillation in a predetermined range of a wavelength band, which is disposed inside the laser resonator, a grating for receiving an output light from the laser medium, an adaptive optics having a mirror for receiving a diffraction light of the grating, and a mirror having a predetermined transparency, which is disposed for receiving a light reflected by the mirror of the adaptive optics after the light is diffracted by the grating.

Further, the present invention has a laser medium capable of performing laser oscillation in a predetermined range of a wavelength band, which is disposed inside the laser resonator, a prism for receiving an output light from the laser medium, an adaptive optics having a mirror for receiving a light that has been dispersed by the prism, and a mirror having a predetermined transparency, which is disposed for receiving a light reflected by the mirror of the adaptive optics.

Further, the present invention has a laser medium capable of performing laser oscillation in a predetermined range of a wavelength band, which is disposed inside the laser resonator, a first adaptive optics having a mirror for receiving an output light from the laser medium, a birefringent filter for receiving a light reflected by the mirror of the first adaptive optics, a second adaptive optics having a mirror for receiving a light transmitted through the birefringent filter, and a mirror having a predetermined transparency, which is disposed for receiving a light reflected by the mirror of the second adaptive optics.

Further, the present invention has a laser diode chip where reflection on one end surface is prevented and total reflection on the other end surface is permitted, a grating for receiving an output light from the one end surface of the laser diode chip, and an adaptive optics having a mirror for receiving the diffraction light of the grating.

Furthermore, in the present invention, the adaptive optics may be either a tracking mirror or a deformable mirror.

Further, in the present invention, an output light from the laser medium capable of performing laser oscillation in a predetermined range of a wavelength band is reflected on the mirror of the adaptive optics to make it incident to a grating such that a first-order diffraction light having a predetermined wavelength from the grating is made incident to the mirror of the adaptive optics, and a light having a wavelength, which has been diffracted by the grating and made incident to the mirror of the adaptive optics, is allowed to reciprocate within a laser resonator to generate laser oscillation and is output.

Further, in the present invention, an output light from the laser medium capable of performing laser oscillation in a predetermined range of a wavelength band is made incident to a grating, a first-order diffraction light having a predetermined wavelength, which has been diffracted by the grating, is made incident perpendicularly to the mirror of an adaptive optics, and a light having a wavelength, which has been made incident perpendicularly to the mirror of the adaptive optics and reflected, is allowed to reciprocate within the laser resonator to generate laser oscillation and is output as a 0-th order light of the grating.

Further, in the present invention, an output light from the laser medium capable of performing laser oscillation in a predetermined range of a wavelength band is made incident to a prism to split the light, a light having a predetermined wavelength, which has been dispersed by the prism, is made incident perpendicularly to the mirror of an adaptive optics, and a light having a wavelength, which has been made incident perpendicularly to the mirror of the adaptive optics and reflected, is allowed to reciprocate within the laser resonator to generate laser oscillation and is output.

Further, in the present invention, an output light from the laser medium capable of performing laser oscillation in a predetermined range of a wavelength band is reflected on the mirror of a first adaptive optics and made incident to a birefringent filter, a light having transmitted through the birefringent filter is made incident to the mirror of a second adaptive optics, and a light having a wavelength, which has been made incident to the mirror of the second adaptive optics and reflected, is allowed to reciprocate within the laser resonator to generate laser oscillation and is output.

Further, in the present invention, an output light from a laser diode chip is made incident to a grating, a first-order diffraction light having a predetermined wavelength, which has been diffracted by the grating, is made incident perpendicularly to the mirror of an adaptive optics, and a light having a wavelength, which has been made incident perpendicularly to the mirror of the adaptive optics and reflected, is allowed to be output as a 0-th order light of the grating.

Further, in the present invention, the adaptive optics may be either the tracking mirror or the deformable mirror.

### Brief Description of the Drawings

Fig. 1 is a schematic constitution exemplary view of a laser device according to a first embodiment of the present invention.
Fig. 2 is a schematic constitution perspective view showing a tracking mirror that is used as an adaptive optics.

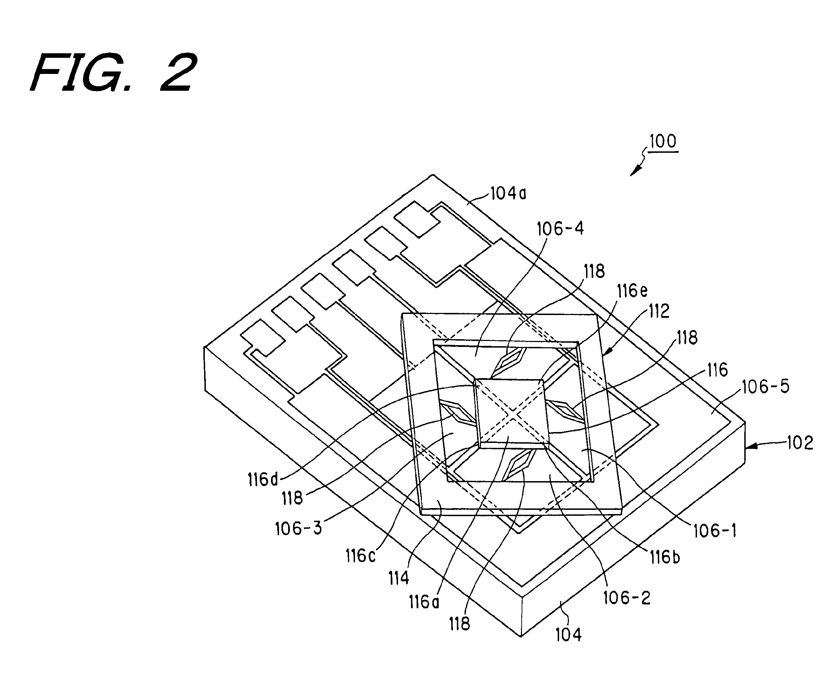

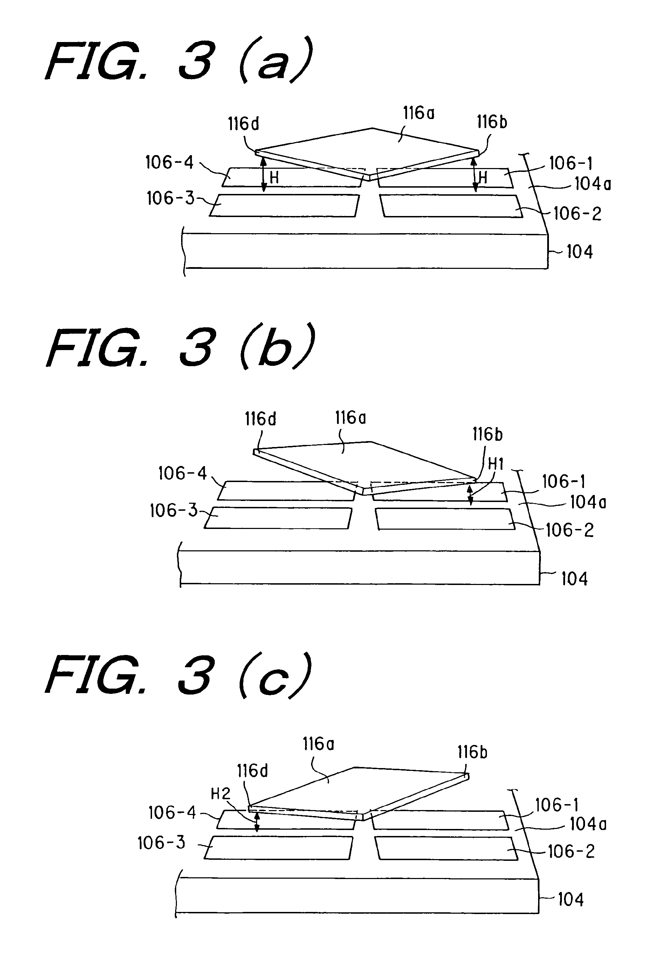

Fig. 3 is an exemplary view showing a principal portion of the tracking mirror shown in Fig. 2, in which Fig. 3(a) is an exemplary view showing a case where voltage of all of electrodes 106-1 to 106-4 is 0V, Fig. 3(b) is an exemplary view showing a case where predetermined voltage is applied to the electrode 106-1 and the electrode 106-2, and the voltage of the electrode 106-3 and the electrode 106-4 is set to 0V, and Fig. 3(c) is an exemplary view showing a case where predetermined voltage is applied to the electrode 106-3 and the electrode 106-4, and the voltage of the electrode 106-1 and the electrode 106-2 is set to 0V.
Fig. 4(a) is a conceptual view showing a case where an output laser beam having the wavelength of 700nm is output from the laser device shown in Fig. 1, and Fig. 4 (b) is a conceptual view showing a case where an output laser beam having the wavelength of 900nm is output from the laser device shown in Fig. 1.
Fig. 5 is a schematic constitution exemplary view of a laser device according to a second embodiment of the present invention.
Fig. 6 is a conceptual view showing a case where an output laser beam having the wavelength of 700nm or the wavelength of 900nm is output from the laser device shown in Fig. 5.
Fig. 7 is a schematic constitution exemplary view of a laser device according to a third embodiment of the present invention.
Fig. 8 is a conceptual view showing a case where an output laser beam having the wavelength of 700nm or the wavelength of 900nm is output from the laser device shown in Fig. 7.
Fig. 9 is a schematic constitution exemplary view of a laser device according to a fourth embodiment of the present invention.
Fig. 10 is a schematic constitution exemplary view of a laser device according to a fifth embodiment of the present invention.
Fig. 11 is a schematic constitution perspective view showing a deformable mirror that is used as an adaptive optics.
Fig. 12 is a sectional view at A-A line of Fig. 11.
Fig. 13 is a schematic constitution exemplary view of a laser device according to another embodiment of the present invention.
Fig. 14 (a) is a graph showing a wavelength tunable region of the laser device shown in Fig. 1, and Fig. 14 (b) is a graph showing a wavelength tunable region of the laser device shown in Fig. 13.

### Explanation of Reference Numerals

10, 10-1, 10-2 Adaptive optics
12, 32, 42 Output side mirror
14 Laser medium
16, 26, 56 Grating (diffraction grating)
20 Controller
22 Mirror
36 Prism
36a Incident surface
36b Output surface
46 Birefringent filter
50 Laser diode chip
52 Lens
100 Tracking mirror
102 Lower member
104 Substrate
104a Surface
106-1 to 106-5 Electrode
112 Upper member
114 Frame
116 Mirror
116a Reflection surface
116b, 116c, 116d, 116e Corner portion
118 Support member
200 Deformable mirror
202 Lower member
204 Substrate
204a Surface
206-1 to 206-7 Electrode
212 Upper member
214 Frame
216 Mirror
216a Reflection surface
216b Surface
218-1 to 218-7 Pillar
220 Adhesive material

### Best Mode for Carrying out the Invention

In the following, description will be made for the embodiments of the laser device and the wavelength selecting method of the laser device according to the present invention based on the accompanying drawings.

Fig. 1 shows the schematic constitution exemplary view of the laser device according to the first embodiment of the present invention.

The laser device of the first embodiment is comprised of an adaptive optics 10 and an output side mirror 12 having a predetermined transparency that constitute the laser resonator, a laser medium 14 disposed inside the laser resonator, and a grating (diffraction grating) 16 as a dispersion element for wavelength selection.

Herein, a Ti:Al₂O₃ laser crystal, for example, can be used as the laser medium 14.

Further, the grating 16 is flat diffraction grating a reflection type, on which a predetermined number of grooves having a predetermined shape are formed, and a flat diffraction grating having diffraction order number of 1 with 1200 grooves/mm can be used.

It is to be noted that an Nd:YAG laser, for example, can be used as an excitation light source for making an excited light incident to the laser resonator.

Then, the adaptive optics 10 is capable of controlling the reflection angle and wavefront of a light to be reflected and includes a mirror for reflecting an incident light by applying active changes to it, and various types are suggested.

In this embodiment, a type of optics capable of changing by controlling only the tilt of a mirror, which is a so-called tracking mirror, should be used as the adaptive optics 10.

Meanwhile, a controller 20 is connected to the adaptive optics 10, and the controller 20 controls the tilt of a mirror 116 (described later) of a tracking mirror 100 that is used as the adaptive optics 10, and the tilt is made changeable.

Fig. 2 shows the schematic constitution perspective view showing the tracking mirror 100, and the tracking mirror 100 is made up of two parts of a lower member 102 and an upper member 112.

The lower member 102 is constituted by having a plate-shaped substrate 104 formed of silicon (Si), and a plurality of electrodes 106-1 - 106-5 printed on the surface 104a of the substrate 104 by using gold (Au).

Herein, the plurality of electrodes 106-1 - 106-5 on the lower member 102 are four electrodes of the electrode 106-1, the electrode 106-2, the electrode 106-3 and the electrode 106-4, which are formed so as to divide a square into four small squares, and the electrode 106-5 formed on the periphery of the electrode 106-1, the electrode 106-2, the electrode 106-3 and the electrode 106-4.

On the other hand, the upper member 112 is comprised of a frame 114 of an approximately rectangular shape and the mirror 116 that includes a reflection surface 116a and is supported by the frame 114 freely movably via support members 118.

The mirror 116 is formed by coating gold (Au) that becomes the reflection surface 116a on the surface of a silicon substrate being a plate-shaped body of an approximately rectangular shape. The mirror 116 is 3.5mm(length)×3.5mm(width)×200µm(thickness), for example, and the dimensions are set such that the mirror has the weight of about 0.05mg.

Then, the frame 114 of the upper member 112 is disposed on the substrate 104 of the lower member 102 in a fixed manner such that the surface 104a of the substrate 104 is positioned on the rear surface of the reflection surface 116a of the mirror 116 and the mirror 116 and the surface 114a of the substrate 104 have a predetermined gap H (several tens of micrometers, for example)(refer to the state shown in Fig. 3(a)).

At this point, the four electrodes of the electrode 106-1, the electrode 106-2, the electrode 106-3 and the electrode 106-4 are severally located so as to face each of four approximately triangular-shaped regions that are separated by two diagonal lines of the mirror 116. Specifically, the corner portion 116b of the mirror 116 is located between the electrode 106-1 and the electrode 106-2, the corner portion 116c of the mirror 116 is located between the electrode 106-2 and the electrode 106-3, the corner portion 116d of the mirror 116 is located between the electrode 106-3 and the electrode 106-4, and the corner portion 116e of the mirror 116 is located between the electrode 106-4 and the electrode 106-1.

In the tracking mirror 100 made up of the two parts of the lower member 102 and the upper member 112, when predetermined voltage is applied to the electrode 106-1 and the electrode 106-2 of the lower member 102 by the control of the controller 20 and the voltage of the electrode 106-3 and the electrode 106-4 is set to 0V, the mirror 116 is drawn to the electrode 106-1 and the electrode 106-2 due to electrostatic effect, a gap H1 (refer to Fig. 3 (b)) between the corner portion 116b of the mirror 116 and the surface 104a of the substrate 104 becomes shorter than the predetermined gap H (refer to Fig. 3(a)), and it causes the mirror 116 to tilt.

Further, when predetermined voltage is applied to the electrode 106-3 and the electrode 106-4 of the lower member 102 and the voltage of the electrode 106-1 and the electrode 106-2 is set to 0V, the mirror 116 is drawn to the electrode 106-3 and the electrode 106-4 due to electrostatic effect, a gap H2 (refer to Fig. 3(c)) between the corner portion 116d of the mirror 116 and the surface 104a of the substrate 104 becomes shorter than the predetermined gap H (refer to Fig. 3 (a)), and it causes the mirror 116 to tilt.

Furthermore, when predetermined voltage is applied to the electrode 106-1 and the electrode 106-4 of the lower member 102 and the voltage of the electrode 106-2 and the electrode 106-3 is set to 0V, or on the contrary, when predetermined voltage is applied to the electrode 106-2 and the electrode 106-3-of the lower member 102 and the voltage of the electrode 106-1 and the electrode 106-4 is set to 0V, the mirror 116 is drawn to the electrodes to which predetermined voltage has been applied due to electrostatic effect, and it causes the mirror 116 to tilt.

Consequently, by changing electrodes, to which predetermined voltage is applied, among the four electrodes 106-1 - 106-4 that are positioned with the predetermined gap H to the mirror 116, or by changing the volume of voltage to be applied to the electrodes, the mirror 116 of the tracking mirror 100 can be tilted in an arbitrary direction by an arbitrary angle, and the tilt of reflection surface 116a of the mirror 116 is thus changeable.

It is to be noted that the maximum changeable angle of the tilt of reflection surface 116a of the mirror 116 of the tracking mirror 100 is 15° in this embodiment, and the angle of the mirror 116 is controllable within the range of ±7.5° from a horizontal state (refer to Fig. 3(a)). Further, the controller 20 performs such control of the angle of the mirror 116 in high-speed of 2kHz to 3kHz. Therefore, in this embodiment, it is possible to shake the angle of the mirror 116 for about 3000 times per second at the maximum angle of 15°.

In the above-described construction, the second harmonic of an Nd:YAG laser is firstly made incident as an excited laser beam to the laser medium 14 to excite the laser medium 14. By exciting the laser medium 14 in this manner, a light having a wide range of wavelength band is output from the laser medium 14, and the light having the wide range of wavelength band is reflected by the mirror 116 of the tracking mirror 100 that has been used as the adaptive optics 10, and made incident to the grating 16.

Then, the light having the wide range of wavelength band, which has been reflected by the mirror 116 of the tracking mirror 100 and made incident to the grating 16, is diffracted by the grating 16 at different diffraction angles by each wavelength and dispersed radially. Specifically, the first-order diffraction light of the grating 16 has different diffraction angles depending on each wavelength. For example, when the flat diffraction grating having diffraction order number of 1 with 1200 grooves/mm is used as the grating 16, the diffraction angle of a +first-order diffraction light of a light having the wavelength of 700nm is 25° and the diffraction angle of a +first-order diffraction light of a light having the wavelength of 900nm is 33°.

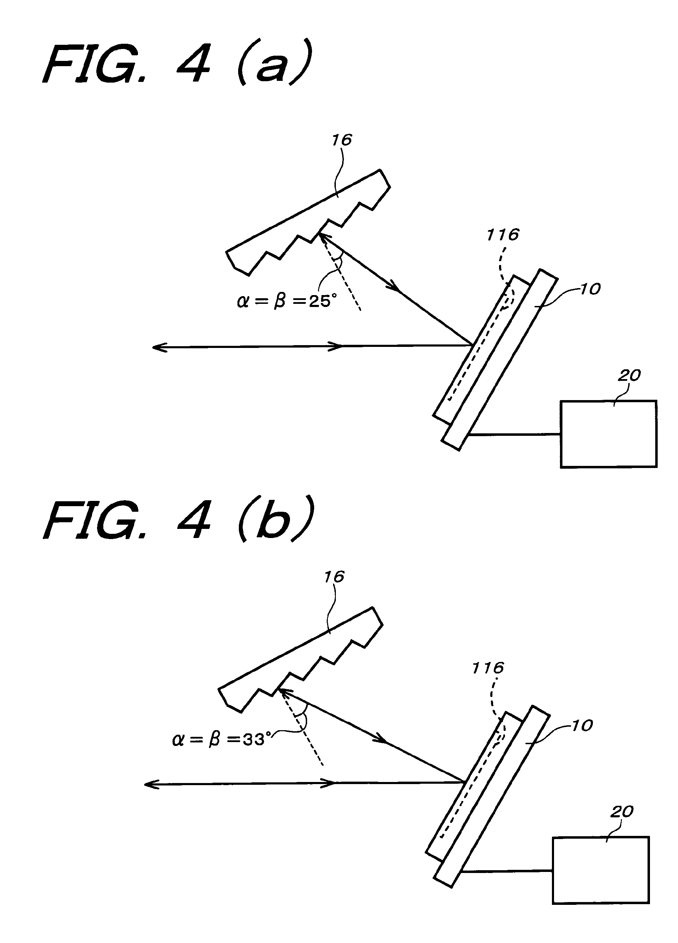

Herein, when the grating 16 is in Littrow mounting, the +first-order diffraction light returns in the direction of the incident light that has been made incident to the grating 16. In other words, an angle that the incident light, which is made incident to the grating 16 of Littrow mounting, forms with the normal (refer to broken line shown in Fig. 4 (a)) of the grating 16, that is, an incident angle α matches an angle that the light diffracted by the grating 16 forms with the normal (refer to broken line shown in Fig. 4(a)) of the grating 16, that is, a diffraction angle β.

For this reason, in the laser device (refer to Fig. 1), the controller 20 changes the angle of the mirror 116 of the tracking mirror 100 used as the adaptive optics 10 such that the output light having the wide range of wavelength band, which has been output form the laser medium 14, is made incident to the grating 16 at the incident angle α that matches the diffraction angle β of the +first-order diffraction light having a predetermined wavelength, that is, to make the grating 16 have Littrow mounting.

For example, when the laser device is allowed to output the output laser beam having the wavelength of 700nm, the output light having the wide range of wavelength band, which has been output form the laser medium 14, is reflected by the mirror 116 of the tracking mirror 100 whose angle has been adjusted by the controller 20, and made incident to the grating 16 at the incident angle α=25° (refer to Fig. 4 (a)) . Then, the +first-order diffraction light having the wavelength of 700nm, which has been diffracted at the diffraction angle β=25° that matches the incident angle α, is made incident to the mirror 116 of the tracking mirror 100 again by the grating 16 of Littrow mounting into the original optical path. Therefore, the light having the wavelength of 700nm reciprocates within the laser resonator that is made up of the adaptive optics 10 and the output side mirror 12.

Furthermore, when the laser device is allowed to output the output laser beam having the wavelength of 900nm, the output light having the wide range of wavelength band, which has been output form the laser medium 14, is reflected by the mirror 116 of the tracking mirror 100 whose angle has been adjusted by the controller 20, and made incident to the grating 16 at the incident angle α=33° (refer to Fig. 4 (b)). Then, the +first-order diffraction light having the wavelength of 900nm, which has been diffracted at the diffraction angle β=33° that matches the incident angle α, is made incident to the mirror 116 of the tracking mirror 100 again by the grating 16 of Littrow mounting into the original optical path. Therefore, the light having the wavelength of 900nm reciprocates within the laser resonator that is made up of the adaptive optics 10 and the output side mirror 12.

As described, when the flat diffraction grating having diffraction order number of 1 with 1200 grooves/mm is used as the grating 16, the diffraction angle β of the +first-order diffraction light of a light having the wavelength from the wavelength of 700nm to the wavelength of 900nm makes between 25° and 33°. Consequently, when the above-described output laser beam having the wavelength from the wavelength of 700nm to the wavelength of 900nm is output from the laser device, the angle of the mirror 116 of the tracking mirror 100 should be adjusted by the controller 20 to make the output light having the wide range of wavelength band, which has been output form the laser medium 14, incident to the grating 16 at the incident angle α between 25° and 33°.

Thus, since the diffraction angle β of the grating 16 is different by each wavelength, the incident angle α for returning the light to the original optical path by the Littrow mounting is also different by each wavelength, so that the mirror 116 of the tracking mirror 100 is adjusted to an angle corresponding to the wavelength, a light having a wavelength of the diffraction angle β that matches the incident angle α is amplified to generate laser oscillation, and a laser beam having the wavelength as an output laser beam can be output from the laser resonator.

Specifically, utilizing the fact that the first-order diffraction light of the grating 16 changes its diffraction angle β depending on the wavelength, when the angle of the adaptive optics 10 is changed to set the grating 16 in Littrow mounting corresponding to the angle, the wavelength of light reciprocating within the laser resonator can be changed to change the wavelength of the output laser beam without mechanically turning the grating 16 to change its angle.

As described above, in the laser device shown in the first embodiment, when the light having the wide range of wavelength band, which has been output from the laser medium 14, is made incident to the grating 16 at an incident angle that matches the diffraction angle of the first-order diffraction light of a light having an arbitrary wavelength by changing the angle of the mirror 16 of the tracking mirror 100 that is used as the adaptive optics 10, the light of an arbitrary wavelength reciprocates within the laser resonator. Thus, the wavelength of the light reciprocating within the laser resonator changes when the angle of the mirror of the adaptive optics 10 is changed, and the wavelength of the output laser beam can be changed.

According to the laser device shown in the first embodiment of the present invention, the mirror 116 of the tracking mirror 100 for changing the angle for wavelength selection is a small and extremely light member, so that the angle of the mirror 116 can be changed in high-speed at 2kHz to 3kHz, for example, and wavelength tunable speed can be faster.

In addition, since the mirror 116 of the tracking mirror 100 changes its angle by being drawn by the electrodes via the air gap utilizing electrostatic effect, mechanical contact such as directly pulling and pushing the mirror 116 is not necessary and fluctuation is small, and the angle can be changed and the angle can be determined very quickly and accurately. Thus, according to the laser device shown in the first embodiment of the present invention, wavelength selection can be performed highly accurately, wavelength reproduction accuracy is good, and stable wavelength selecting action can be realized.

Further, in the laser device shown in the first embodiment of the present invention, since the flat diffraction grating having diffraction order number of 1 with 1200 grooves/mm is used as the grating 16, a spectrum width of laser beam to be oscillated can be made as narrow as about 0.01nm or less, and the wavelength selecting action can be realized in narrow spectrum.

It is to be noted that the spectrum width (about 0.01nm or less) of a laser beam to be oscillated by the laser device according to the present invention is narrower than a spectrum width (about 0.1nm) of a laser beam oscillated by high-speed wavelength selection using a wavelength selecting element that uses acousto-optic effect, for example.

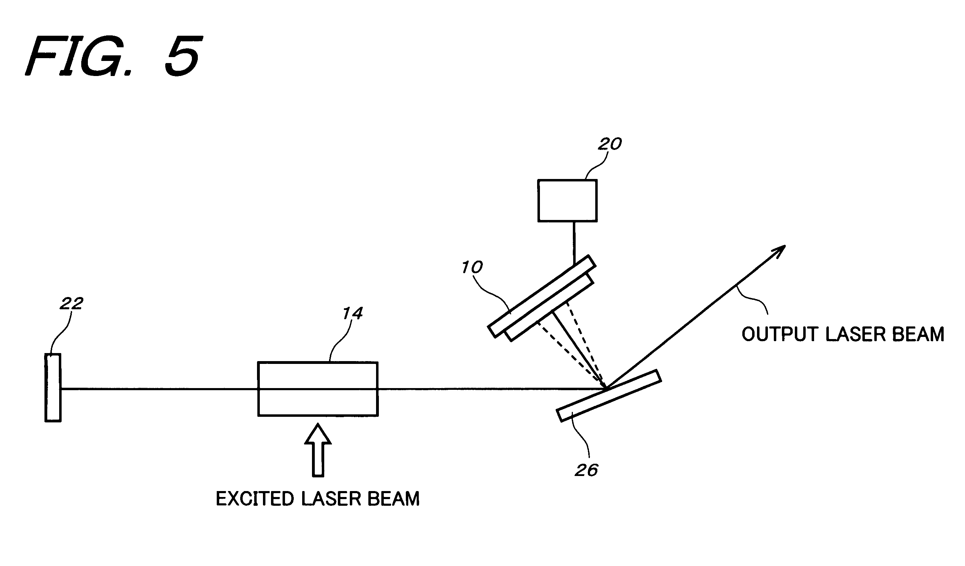

Fig. 5 shows the schematic constitution exemplary view of the laser device according to the second embodiment of the present invention. It is to be noted that the same reference numerals are applied to the same constituent members as the constituent members shown in Fig. 1 to Fig. 4 for easy understanding.

The laser device according to the second embodiment is comprised of the adaptive optics 10 and a mirror 22 having a predetermined transparency, which constitute the laser resonator, the laser medium 14 disposed inside the laser resonator, and a grating (diffraction grating) 26 as the dispersion element for wavelength selection.

Herein, the tracking mirror 100 (refer to Fig. 2) is used as the adaptive optics 10 in the same manner as the above-described first embodiment.

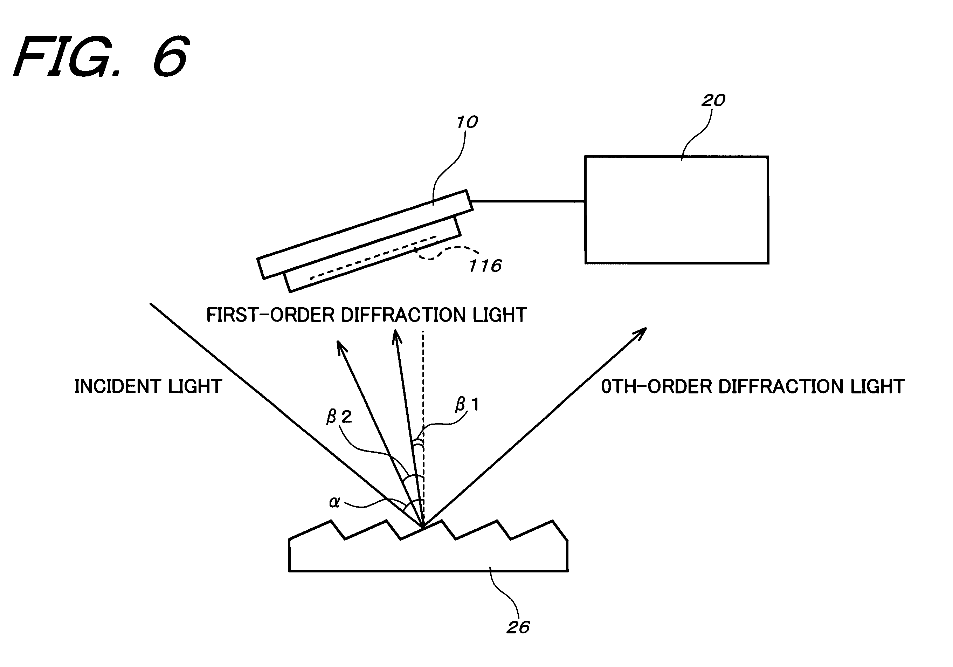

Further, the flat diffraction grating of reflection type having diffraction order number of 1 with 1200 grooves/mm, for example, can be used as the grating 26. It is to be noted that the grating 26 is disposed such that an angle that a light having the wide range of wavelength band (described later) output from the laser medium 14, which is made incident to the grating 26, forms with the normal (refer to broken line shown in Fig. 6) of the grating 26, that is, the incident angle α becomes 50°.

In the above-described construction, the second harmonic of an Nd:YAG laser is made incident to the laser medium 14 as the excited laser beam to excite the laser medium 14. By exciting the laser medium 14 in this manner, light having the wide range of wavelength band is output from the laser medium 14, and the light having the wide range of wavelength band is made incident to the grating 26 at the angle of α=50°.

Then, the light having the wide range of wavelength band, which has been made incident to the grating 26, is diffracted by the grating 26 at different diffraction angles by each wavelength and dispersed radially. Specifically, the first-order diffraction light of the grating 26 has different diffraction angles depending on a wavelength. For example, when the flat diffraction grating having diffraction order number of 1 with 1200 grooves/mm is used as the grating 26, the diffraction angle β1 of the +first-order diffraction light of the light having the wavelength of 700nm is 4° and the diffraction angle β2 of the +first-order diffraction light of the light having the wavelength of 900nm is 18° when the light having the wide range of wavelength band is made incident to the grating 26 at the incident angle of α=50° (refer to Fig. 6) .

For this reason, in the laser device (refer to Fig. 5), the controller 20 changes the angle of the mirror 116 of the tracking mirror 100 such that the first-order diffraction light having a predetermined wavelength is made incident perpendicularly to the mirror 116 of the tracking mirror 100 that has been used as the adaptive optics 10.

For example, when the output laser beam having the wavelength of 700nm is output from the laser device, the controller 20 adjusts the angle of the mirror 116 of the tracking mirror 100 to allow the mirror 116 to tilt by 4° with respect to the grating 26, and the diffraction light having the diffraction angle of β1=4° (refer to Fig. 6) , that is, the light having the wavelength of 700nm is made incident perpendicularly to the mirror 116. Then, the light having the wavelength of 700nm, which has been made incident perpendicularly to the mirror 116 of the tracking mirror 100, is reflected by the mirror 116 to be made incident to the grating 26 again, and the light returns to the laser resonator constituted by the adaptive optics 10 and the mirror 22 to reciprocate within the resonator.

Further, when the output laser beam having the wavelength of 900nm is output from the laser device, the controller 20 adjusts the angle of the mirror 116 of the tracking mirror 100 to allow the mirror 116 to tilt by 18° with respect to the grating 26, and the diffraction light having the diffraction angle of β2=18° (refer to Fig. 6), that is, the light having the wavelength of 900nm is made incident perpendicularly to the mirror 116. Then, the light having the wavelength of 900nm, which has been made incident perpendicularly to the mirror 116 of the tracking mirror 100, is reflected by the mirror 116 to be made incident to the grating 26 again, and the light returns to the laser resonator constituted by the adaptive optics 10 and the mirror 22 to reciprocate within the resonator.

As described, when the flat diffraction grating having diffraction order number of 1 with 1200 grooves/mm is used as the grating 26, the diffraction angle β of the +first-order diffraction light of the light having the wavelength from the wavelength of 700nm to the wavelength of 900nm makes between 4° and 18°. Consequently, when the above-described output laser beam having the wavelength from the wavelength of 700nm to the wavelength of 900nm should be output from the laser device, the angle of the mirror 116 of the tracking mirror 100 is allowed to tilt between 4° and 18° with respect to the grating 26 by the controller 20, and the output light having a wavelength between the wavelength of 700nm and the wavelength of 900nm is made incident perpendicularly to the mirror 116.

Since the diffraction angle of the grating 26 is different depending on a wavelength, the light having the wavelength, which has been made incident perpendicularly to the mirror 116, is amplified to generate laser oscillation when the mirror 116 of the tracking mirror 100 is adjusted to an angle corresponding to a wavelength of a desired output laser beam, a laser beam having the wavelength is output as the 0-th order light of the grating 26 from the laser resonator, and the output laser beam can be obtained.

In other words, utilizing the fact that the first-order diffraction light of the grating 26 changes its diffraction angle depending on the wavelength, when the angle of the mirror of the adaptive optics 10 is changed so as to perpendicularly receive the first-order light having a predetermined wavelength, the wavelength of the light reciprocating within the laser resonator can be changed to change the wavelength of the output laser beam without mechanically turning the grating 26 to change its angle.

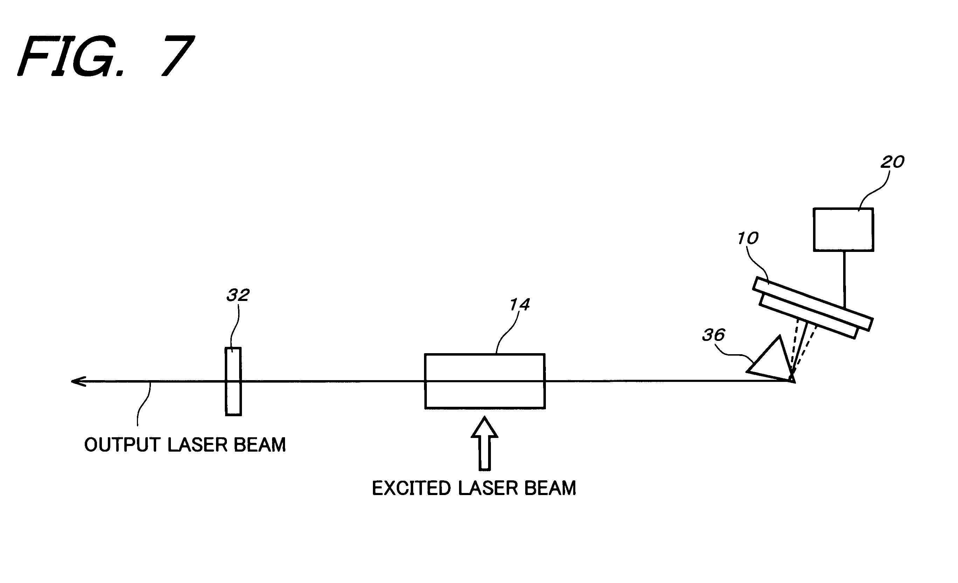

Fig. 7 shows the schematic constitution exemplary view of the laser device according to the third embodiment of the present invention. It is to be noted that the same reference numerals are applied to the same constituent members as the constituent members shown in Fig. 1 to Fig. 4 for easy understanding.

The laser device according to the third embodiment is comprised of the adaptive optics 10 and an output side mirror 32 having predetermined transparency, which constitute the laser resonator, the laser medium 14 disposed inside the laser resonator, and a prism 36 as a dispersion element for wavelength selection.

Herein, the tracking mirror 100 (refer to Fig. 2) should be used as the adaptive optics 10 similar to the above-described first embodiment.

Further, an SF10 Brewster-cut prism having the material of SF11 and the apex angle of 59.7°, for example, can be used as the prism 36. It is to be noted that the prism 36 is disposed so as to receive the light having the wide range of wavelength band (described later) that has been output from the laser medium 14 at the incident angle α=59.7°.

In the above-described construction, the second harmonic of an Nd:YAG laser is made incident to the laser medium 14 as the excited laser beam to excite the laser medium 14. By exciting the laser medium 14 in this manner, a light having the wide range of wavelength band is output from the laser medium 14, and the light having the wide range of wavelength band is made incident to the incident surface 36a of the prism 36 at the incident angle of α=59.7°.

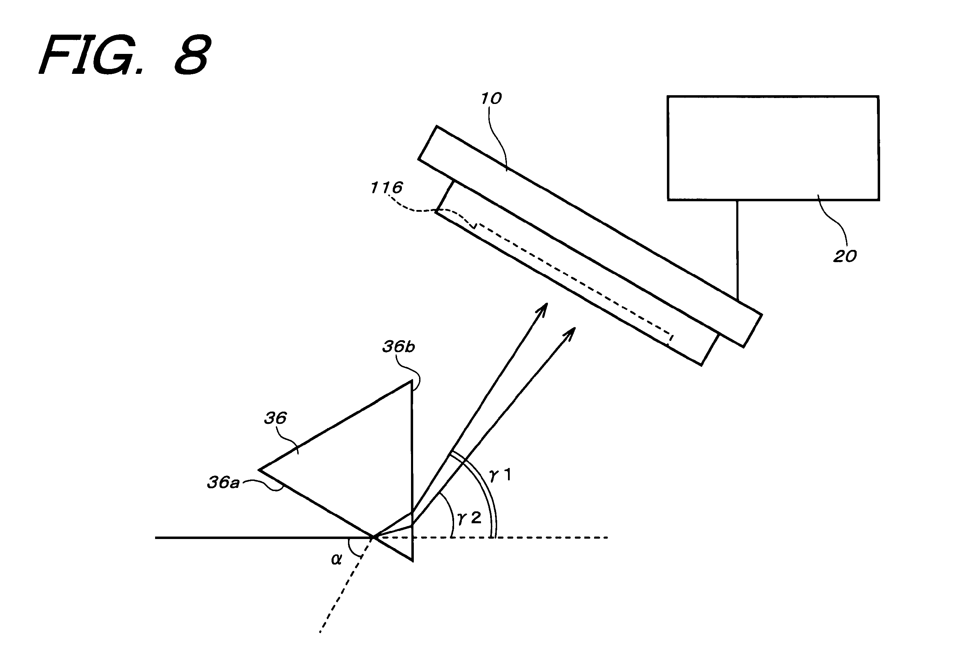

Then, the light having the wide range of wavelength band, which has been made incident to the prism 36, is diffracted by the prism 36 at different diffraction angles by each wavelength and dispersed radially. Specifically, the light dispersed by the prism 36 has different dispersion angles depending on a wavelength. For example, when the SF10 Brewster-cut prism having the material of SF11 and the apex angle of 59.7° is used as the prism 36, the dispersion angle γ1 of the light having the wavelength of 700nm is 57.75° and the dispersion angle γ2 of the light having the wavelength of 900nm is 56.60° when the light having the wide range of wavelength band is made incident to the prism 36 at the incident angle of α=59.7° (refer to Fig. 8) .

For this reason, in the laser device (refer to Fig. 7), the controller 20 changes the angle of the mirror 116 of the tracking mirror 100 such that the light having a predetermined wavelength, which has been dispersed by the prism 36, is made incident perpendicularly to the mirror 116 of the tracking mirror 100 that has been used as the adaptive optics 10.

For example, when the output laser beam having the wavelength of 700nm is output from the laser device, the controller 20 adjusts the angle of the mirror 116 of the tracking mirror 100 to allow the mirror 116 to tilt by a predetermined angle with respect to the output surface 36b of the prism 36, and the diffusion light having the diffusion angle γ1=57.75° (refer to Fig. 8), that is, the light having the wavelength of 700nm is made incident perpendicularly to the mirror 116. Then, the light having the wavelength of 700nm, which has been made incident perpendicularly to the mirror 116 of the tracking mirror 100, is reflected by the mirror 116 to be made incident to the prism 36 again, and the light returns to the laser resonator constituted by the adaptive optics 10 and the output side mirror 32 to reciprocate within the resonator.

Further, when the output laser beam having the wavelength of 900nm is output from the laser device, the controller 20 adjusts the angle of the mirror 116 of the tracking mirror 100 to allow the mirror 116 to tilt by a predetermined angle with respect to the output surface 36b of the prism 36, and the diffusion light having the diffusion angle γ2=56.60° (refer to Fig. 8), that is, the light having the wavelength of 900nm is made incident perpendicularly to the mirror 116. Then, the light having the wavelength of 900nm, which has been made incident perpendicularly to the mirror 116 of the tracking mirror 100, is reflected by the mirror 116 to be made incident to the prism 36 again, and the light returns to the laser resonator constituted by the adaptive optics 10 and the output side mirror 32 to reciprocate within the resonator.

As described, when the SF10 Brewster-cut prism having the material of SF11 and the apex angle of 59.7° is used as the prism 36, the diffusion angle γ of the diffusion light of the light having the wavelength between the wavelength of 700nm and the wavelength of 900nm is between 57.75° and 56.60°. Therefore, when outputting the above-described output laser beam having the wavelength between the wavelength of 700nm and the wavelength of 900nm from the laser device, the angle of the mirror 116 of the tracking mirror 100 is allowed to tilt within a predetermined range with respect to the prism 36 by the controller 20, and the output light having a wavelength between the wavelength of 700nm and the wavelength of 900nm should be made incident perpendicularly to the mirror 116.

Since the diffusion angle of the prism 36 is different depending on a wavelength, the mirror 116 of the tracking mirror 100 is adjusted to an angle corresponding to a wavelength of a desired output laser, the light having the wavelength that has been made incident perpendicularly to the mirror 116 is amplified to generate laser oscillation, and the laser beam having the wavelength from the laser resonator can be output as the output laser beam from the output side mirror 32.

In other words, utilizing the dispersion by the prism 36, when the angle of the mirror of the adaptive optics 10 is changed so as to perpendicularly receive the light having a predetermined wavelength, the wavelength of the light reciprocating within the laser resonator can be changed to change the wavelength of the output laser beam without mechanically turning the prism 36 to change its angle.

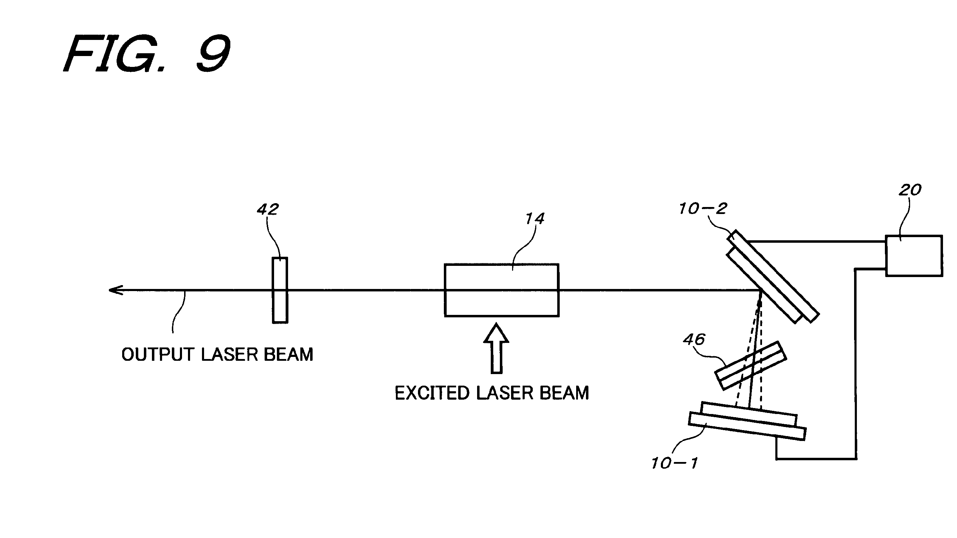

Fig. 9 shows the schematic constitution exemplary view of the laser device according to the fourth embodiment of the present invention. It is to be noted that the same reference numerals are applied to the same constituent members as the constituent members shown in Fig. 1 to Fig. 4 for easy understanding.

Specifically, the laser device according to the fourth embodiment is comprised of an adaptive optics 10-1 and an output side mirror 42 having predetermined transparency, which constitutes the laser resonator, the laser medium 14 disposed inside the laser resonator, a birefringent filter 46 as the dispersion element for wavelength selection, and an adaptive optics 10-2 disposed between the birefringent filter 46 and the laser medium 14.

Herein, the tracking mirror 100 (refer to Fig. 2) should be used as the adaptive optics 10-1 and the adaptive optics 10-2 similar to the above-described first embodiment.

Further, a 3-plate birefringent filter made of quartz having the central wavelength of 800nm, for example, can be used as the birefringent filter 46. It is to be noted that the birefringent filter 46 is disposed so as to position between the adaptive optics 10-1 and the adaptive optics 10-2.

In the above-described construction, the second harmonic of an Nd:YAG laser is firstly made incident as an excited laser beam to the laser medium 14 to excite the laser medium 14. By exciting the laser medium 14 in this manner, a light having a wide range of wavelength band is output from the laser medium 14, and the light having the wide range of wavelength band is reflected by the mirror 116 of the tracking mirror 100 that has been used as the adaptive optics 10-2, and made incident to the birefringent filter 46.

Herein, the birefringent filter 46 selectively outputs a light having a predetermined wavelength corresponding to a transmission angle of the incident light that is made incident to the birefringent filter 46. For example, in the case where the 3-plate birefringent filter made of quartz having the central wavelength of 800nm is used as the birefringent filter 46, a light having the wavelength of 790nm is output from the birefringent filter 46 when the light having a wide range of wavelength band, which has been output from the laser medium 14, is made incident to the birefringent filter 46 at the transmission angle of 30°, and a light having the wavelength of 840nm is output from the birefringent filter 46 when the light is made incident to the birefringent filter 46 at the transmission angle of 40°.

Therefore, in the laser device (refer to Fig. 9), the controller 20 changes the angle of the mirror 116 of the tracking mirror 100 that has been used as the adaptive optics 10-2 such that the light having a wide range of wavelength band, which has been output from the laser medium 14, is made incident to the birefringent filter 46 at a transmission angle where a light having a predetermined wavelength can be output from the birefringent filter 46.

Then, the light having a wide range of wavelength band, which has been output from the laser medium 14, is reflected by the mirror 116 of the tracking mirror 100 that has been used as the adaptive optics 10-2, and is made incident to the birefringent filter 46 at the transmission angle where the light having a predetermined wavelength can be output from the birefringent filter 46. As a result, the light having a predetermined wavelength is output transmitting through the birefringent filter 46.

Consequently, the light having a predetermined wavelength, which has been output from the birefringent filter 46, is reflected by the mirror 116 of the tracking mirror 100 that has been used as the adaptive optics 10-1 whose angle is adjusted by the controller 20, and is made incident to the birefringent filter 46 again. Then, the light returns to the laser resonator constituted by the adaptive optics 10-1 and the output mirror 42 to reciprocate within the resonator.

Since the transmission angle of the birefringent filter 46 is different depending on a wavelength, the mirror 116 of the tracking mirror 100 that has been used as the adaptive optics 10-2 is adjusted such that a light having a wavelength of a desired output laser beam is output from the birefringent filter 46, the light having a wavelength that has been made output from the birefringent filter 46 is amplified to generate laser oscillation, and the laser beam having the wavelength from the laser resonator can be output as the output laser beam from the output side mirror 42.

In other words, utilizing the wavelength selection by the birefringent filter 46, when the angle of the mirrors of the adaptive optics 10-1 and the adaptive optics 10-2 is changed so as to change the transmission angle of the birefringent filter 46 while resonant state is maintained, the wavelength of the light reciprocating within the laser resonator can be changed to change the wavelength of the output laser beam without mechanically turning the birefringent filter 46 to change its angle.

The effect same as the above-described laser device shown in the first embodiment (refer to Fig. 1) is also exerted in the laser device shown in the second embodiment (refer to Fig. 5), the laser device shown in the third embodiment (refer to Fig. 7), and the laser device shown in the fourth embodiment (refer to Fig. 9), which have been described above. When the angle of the mirrors of the adaptive optics 10, 10-1, 10-2 is changed, the wavelength of the light reciprocating within the laser resonator is changed, so that the wavelength of the output laser beam can be changed and wavelength tunable speed can be also made faster. Further, wavelength selection can be performed accurately, wavelength reproduction accuracy is good, and stable and narrow spectrum wavelength selecting action can be realized.

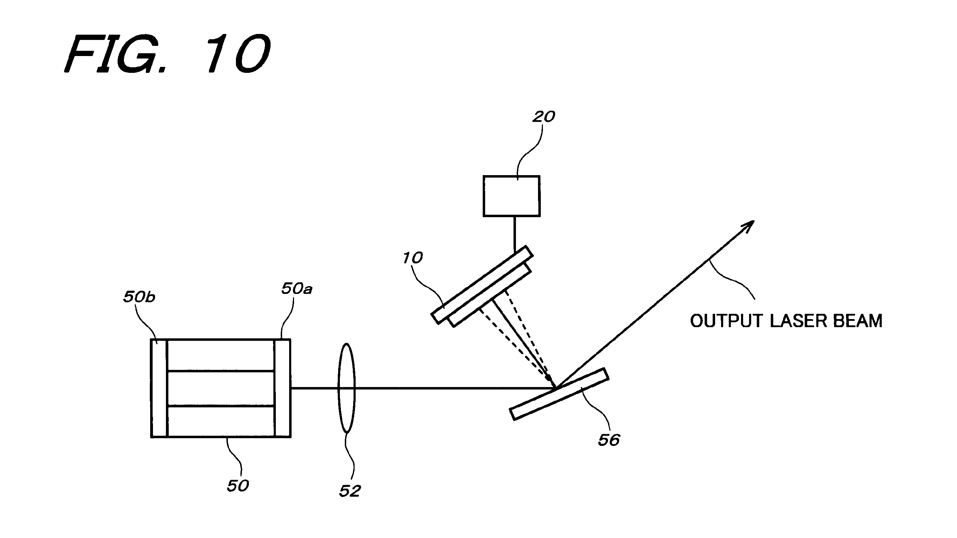

Fig. 10 shows the schematic constitution exemplary view of the laser device according to the fifth embodiment of the present invention. It is to be noted that the same reference numerals are applied to the same constituent members as the constituent members shown in Fig. 1 to Fig. 4 for easy understanding.

The semiconductor laser being the laser device shown in Fig. 10 is comprised of a laser diode chip 50, a lens 52 for receiving an output light from the laser diode chip 50, the adaptive optics 10, and a grating (diffraction grating) 56 as the diffusion element for wavelength selection.

Herein, AR coating is applied on one end surface 50a of the adaptive optics 10 of the laser diode chip 50, and total reflection coating is applied on the other end surface 50b. Then, an output light from the end surface 50a from which reflection is prevented by AR coating is designed to be made incident to the lens 52.

The lens 52 transforms the output light from the laser diode chip 50 into a parallel light, and makes the light incident to the grating 56.

Further, a flat diffraction grating of a reflection type, which has diffraction order number of 1 with 300 grooves/mm, for example, can be used as the grating 56. It is to be noted that the grating 56 is disposed such that an angle that the output light from the lens 52, which is made incident to the grating 56, forms with the normal of the grating 26, that is, the incident angle α becomes 30°.

Then, a type of adaptive optics 10 where the shape of a film-shaped mirror is controlled and changeable, which is referred to as a so-called deformable mirror, should be used in this embodiment.

It is to be noted that the controller 20 is connected to the adaptive optics 10, and the controller 20 controls the shape of a mirror 216 (described later) of a deformable mirror 200 that is used as the adaptive optics 10, and the reflection surface 216a of the mirror 216 is designed to be changeable.

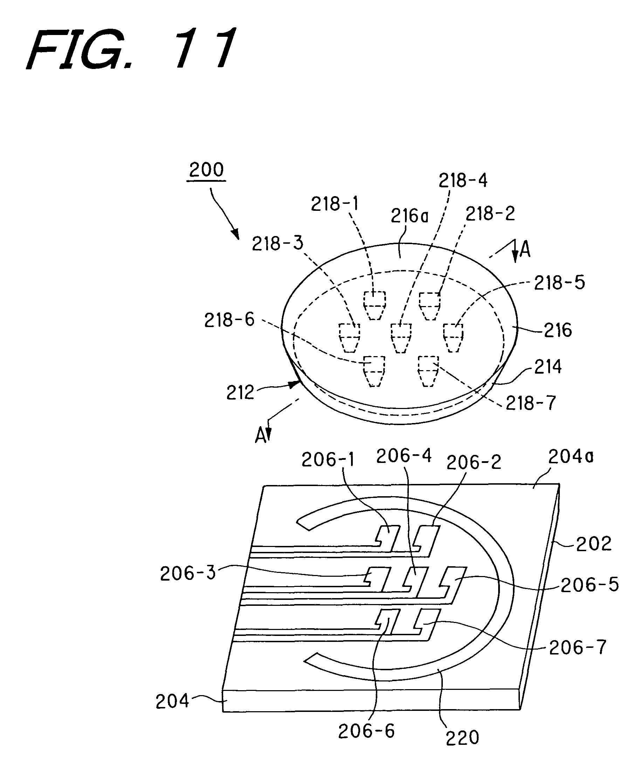

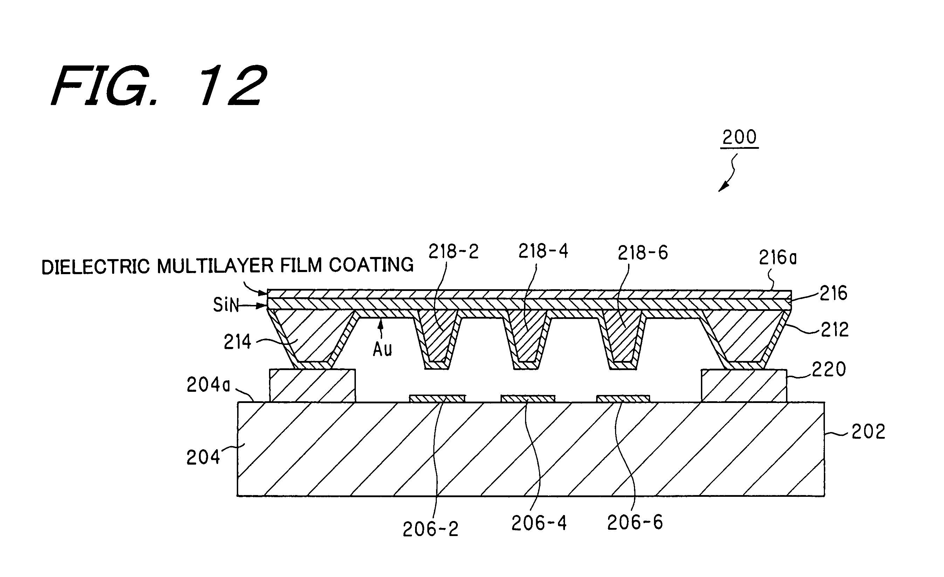

Fig. 11 shows the schematic constitution perspective view showing the deformable mirror 200, and Fig. 12 shows the sectional view at A-A line of Fig. 11. The deformable mirror 200 is made up of the two parts of a lower member 202 and an upper member 212.

The lower member 202 is comprised of a substrate 204 of a plate-shaped body formed by silicon crystal, and a plurality of electrodes 206-1 - 206-7 that are printed on the surface 204a of the substrate 204 using gold (Au).

On the other hand, the upper member 212 is comprised of a frame 214 of an approximate ring shape, a mirror 216 of a film state, which includes the reflection surface 216a and is formed on the frame 214, and a plurality of pillars 218-1 - 218-7 of a protruded state, which are disposed on a rear side surface of the reflection surface 216a of the mirror 216.

It is to be noted that the frame 214 and the pillars 218-1 - 218-7 are formed of silicon crystal. In addition, the reflection surface 216a of the mirror 216 is formed in such a manner that dielectric multilayer film coating is applied on silicon nitride (SiN). Then, gold is coated on a surface 216b that positions on the rear side of the reflection surface 216a of the mirror 216 and on the periphery of the frame 214.

Furthermore, the pillars 218-1 - 218-7 of the upper member 212 are formed in a number matching the total number of the electrodes 206-1 - 206-7 of the lower member 202 on positions corresponding to the electrodes 206-1 - 206-7 of the lower member 202.

Herein, when the upper member 212 is fixed on the surface 204a of the substrate 204 of the lower member 202 by adhesive material 220 and the two parts of the upper member 212 and the lower member 202 are bonded to constitute the deformable mirror 200, the pillars 218-1 - 218-7 of the upper member 212 and the electrodes 206-1 - 206-7 of the lower member 202 are arranged in a positional relationship so as to face to each other with a predetermined gap (several tens of micrometers, for example) .

Incidentally, in the deformable mirror 202 shown in Fig. 11, seven pillars 218-1 - 218-7 of the upper member 212 are arranged to face seven electrodes 206-1 - 206-7 of the lower member 202. However, the numbers of the pillars 218-1 - 218-7 and the electrodes 206-1 - 206-7 are not limited to this, the pillars of the upper member 212 and the electrodes of the lower member 202 can be formed in arbitrary numbers such that they can face to each other, and one hundred or more pillars and the electrodes may be formed, for example.

In the deformable mirror 200 made up of the two parts of the lower member 202 and the upper member 212, when predetermined voltage is applied to the electrode 206-1 of the lower member 202 and the voltage of the electrodes 206-2 to 206-7 is set to 0V by the control of the controller 20, the mirror 216 is drawn to the electrode 206-1 due to electrostatic effect, and the reflection surface 216a that has been a smooth flat shape is deformed into a concave surface shape where a region facing the electrode 206-1 is recessed.

As described, by controlling each voltage of the electrodes 206-1 to 206-7 of the lower member 202 by the controller 20, the mirror 216 of the deformable mirror 200 is that the shape of the mirror 216 is changeable.

It is to be noted in this embodiment that an angle at which the tilt of the reflection surface 26a of the mirror 216 of the deformable mirror 200 is changeable is 1° at maximum, and the angle of the mirror 216 is controllable within the range of ±0.5° from a horizontal state (refer to Fig. 12). Further, such control of the angle of the mirror 216 is performed by the controller 20 in high-speed of 2kHz to 3kHz. Therefore, in this embodiment, it is possible to shake the angle of the mirror 216 for about 3000 times per second at the maximum angle of 1°.

In the above-described construction, the output light having the wide range of wavelength band (800nm to 850nm, for example) from the end surface 50a of the laser diode chip 50 is made incident to the lens 52, transformed into a parallel light by the lens 52, and made incident to the grating 56 at the angle of α=30° .

Then, the light having the wide range of wavelength band, which has been made incident to the grating 56, is diffracted by the grating 56 at different diffraction angles by each wavelength and dispersed radially. Specifically, the first-order diffraction light of the grating 56 has different diffraction angles depending on a wavelength. For example, when the flat diffraction grating having diffraction order number of 1 with 300 grooves/mm is used as the grating 56, the diffraction angle of the +first-order diffraction light of the light having the wavelength of 800nm is 13.89° and the diffraction angle of the +first-order diffraction light of the light having the wavelength of 850nm is 14.77°.

For this reason, in the semiconductor laser (refer to Fig. 10), the controller 20 changes the angle of the mirror 216 of the deformable mirror 200 such that the first-order diffraction light having a predetermined wavelength is made incident perpendicularly to the reflection surface 216a of the mirror 216 of the deformable mirror 200 that has been used as the adaptive optics 10.

For example, when the semiconductor laser is allowed to output the output laser beam having the wavelength of 800nm, the controller 20 adjusts the angle of the mirror 216 of the deformable mirror 200 to tilt the reflection surface 216a of the mirror 216 by a predetermined angle with respect to the grating 56, and the diffraction light having the diffraction angle of 13.89°, that is, the light having the wavelength of 800nm is made incident perpendicularly to the mirror 216.

Furthermore, when the semiconductor laser is allowed to output the output laser beam having the wavelength of 850nm, the controller 20 adjusts the angle of the mirror 216 of the deformable mirror 200 to tilt the reflection surface 216a of the mirror 216 by a predetermined angle with respect to the grating 56, and the diffraction light having the diffraction angle of 14.77°, that is, the light having the wavelength of 850nm is made incident perpendicularly to the mirror 216.

As described, when the flat diffraction grating having diffraction order number of 1 with 300 grooves/mm is used as the grating 56, the diffraction angle of the +first-order diffraction light of the light having the wavelength from the wavelength of 800nm to the wavelength of 850nm makes between 13.89° and 14.77°. Consequently, when the above-described output laser beam having the wavelength from the wavelength of 800nm to the wavelength of 850nm is output from the semiconductor laser, the angle of the mirror 216 of the deformable mirror 200 is allowed to tilt within a predetermined range with respect to the grating 56 by the controller 20, and the light having the wavelength from the wavelength of 800nm to the wavelength of 850nm should be made incident perpendicularly to the mirror 216.

Then, the light having a predetermined wavelength, which has been made incident perpendicularly to the reflection surface 216a of the mirror 216 of the deformable mirror 200, is reflected by the reflection surface 216a to be made incident to the grating 56 again, returns to the original optical path, and goes back to the laser diode chip 50.

Thus, since the diffraction angle of the grating 56 is different by each wavelength, when the mirror 216 of the deformable mirror 200 is adjusted by the controller 20 to an angle corresponding to the wavelength of a desired output laser beam, the light having a wavelength which has been made incident perpendicularly to the reflection surface 216a of the mirror 216 is amplified to generate laser oscillation, and the light can be out put as the 0-th order light of the grating 56.

Specifically, utilizing the fact that the first-order diffraction light of the grating 56 changes its diffraction angle depending on the wavelength, when the angle of the mirror of the adaptive optics 10 is changed so as to perpendicularly receive the first-order diffraction light having a predetermined wavelength, the wavelength of a light going back to the laser diode chip 50 can be changed to change the wavelength of the output laser beam without mechanically turning the grating 56 to change its angle.

Then, the effect same as the above-described laser device shown in the first embodiment (refer to Fig. 1) is also exerted in the laser device shown in the semiconductor laser of the present invention (refer to Fig. 10). When the angle of the mirror of the adaptive optics 10 is changed, the wavelength of the light going back to the laser diode chip 50 is changed, so that the wavelength of the output laser beam can be changed and wavelength tunable speed can be also made faster. Further, wavelength selection can be performed accurately, wavelength reproduction accuracy is good, and stable and narrow spectrum wavelength selecting action can be realized.

Meanwhile, it is known that wavelength is changed by changing temperature in a semiconductor laser, but changing speed of wavelength is extremely slow and a spectrum width is as wide as several nanometers in such a case.

Consequently, it is suggested to constitute an external resonator, and, in a conventional semiconductor laser having the external resonator, a light diffracted by a grating arranged outside the laser diode has been returned to the original optical path by a mechanically turning total reflection mirror. Therefore, the sweep rate by the conventional semiconductor laser is 100ns/sec and the line width of spectrum is about 300kHz (about 1pm) or less, which are far behind the sweep rate of 10000nm/sec that are realized by the semiconductor laser (refer to Fig. 10) according to the present invention.

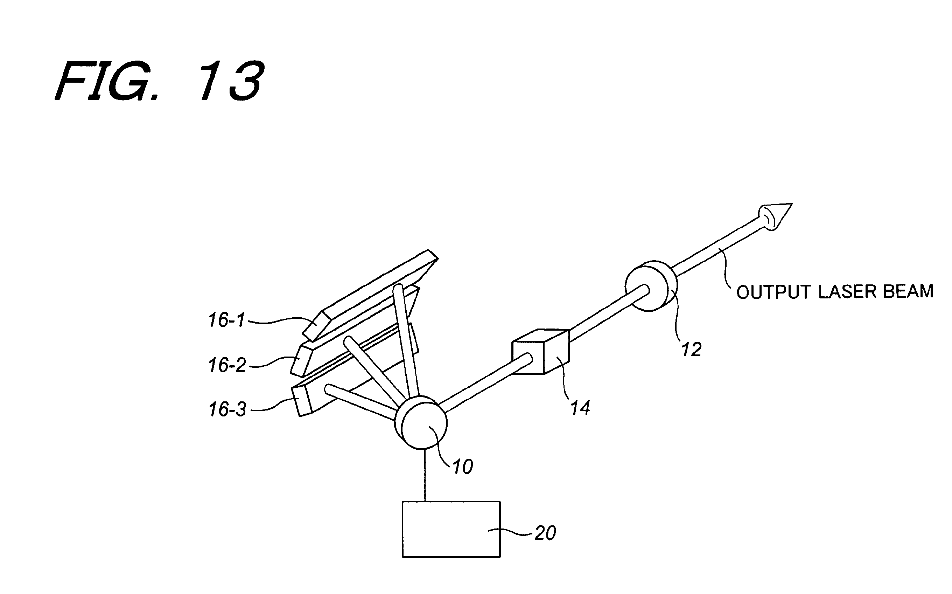

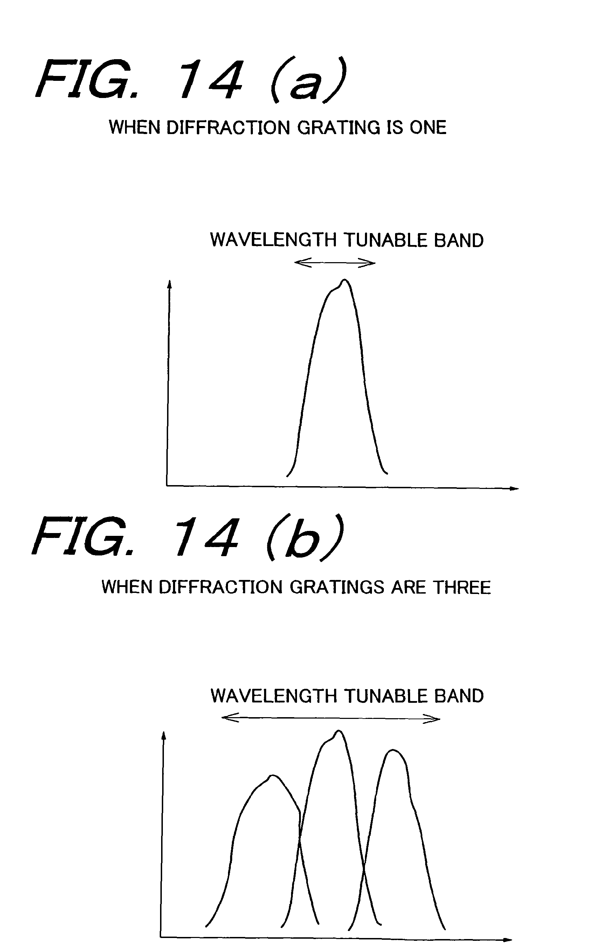

It is to be noted that the above-described embodiments can be modified as described in the following (1) to (7).
(1) In the above-described embodiments, a Ti:Al₂O₃ laser crystal was used as the laser medium 14 and the second harmonic of an Nd:YAG laser was used as the excited laser beam, but it goes without saying that the present invention is not limited to them. For example, another type of laser medium such as an LiSAF laser crystal, an LiCAF laser crystal, a liquid laser using dye solution or the like, or an excitation laser light source such as a continuous-wave solid state laser, a continuous-wave semiconductor laser and a continuous-wave Ar ion laser may be used.
(2) In the above-described embodiments, various kinds of designs or the like were exemplified as the grating 16, grating 26, prism 36, birefringent filter 46 and grating 56, but it goes without saying that the present invention is not limited to them. A grating, a prism or a birefringent filter other than the ones designed as exemplified may be used. Further, another type of diffusion element or wavelength selecting member, which is different from the grating, prism or birefringent filter, may be used.
   Then, by selecting a type of diffraction grating, the spectrum width of laser beam oscillated from the laser device according to the present invention can be made wider or narrower. Specifically, the spectrum width of laser beam oscillated from the laser device according to the present invention can be made narrower when the number of grooves of the grating 16 or the grating 26 is increased. In addition, the total length of the laser resonator may be longer in order to make the spectrum width of laser beam, which is oscillated from the laser device according to the present invention, narrower.
   It is to be noted that the wavelength band and the spectrum width of laser beam to be oscillated are in a trade-off relationship in the laser device according to the present invention where the above-described various modifications can be made, and it is possible to make the spectrum width far narrower comparing to a limit to which the spectrum width of laser beam, which is oscillated by high-speed wavelength selection using the wavelength selecting element that uses acousto-optic effect, can be made narrower.
(3) In the laser device of the above-described first embodiment (refer to Fig. 1) , a single grating 16 was disposed, but it goes without saying that the present invention is not limited to this. A plurality of gratings (diffraction grating) having high efficiency in different wavelength bands from each other may be disposed.
   For example, Fig. 13 shows the schematic constitution exemplary view of the laser device in which a plurality of gratings 16-1, 16-2, 16-3 are disposed instead of the single grating 16 of the laser device of the first embodiment (refer to Fig. 1).
   As described in the laser device shown in Fig. 12, it is possible to move the mirror 116 of the tracking mirror 100 (refer to Fig. 2) that is used as the adaptive optics 10 not only one-dimensionally but also two-dimensionally even when the grating 16-1, the grating 16-2 and the grating 16-3 are disposed, which have high efficiency in different wavelength bands from each other, so that the mirror can receive the diffraction light from the three gratings 16-1, 16-2, 16-3.
   As a result, according to the laser device shown in Fig. 12, each of the three gratings 16-1, 16-2, 16-3 covers a different wavelength band (refer to Fig. 14(b)), and it is possible to cover a continuous and wide range of wavelength band or a plurality of wavelength bands whereas the wavelength band is limited when the single grating is disposed (refer to Fig. 14 (a)) .
(4) In the laser device of the above-described first to fourth embodiments, the tracking mirror 100 (refer to Fig. 2) was used as the adaptive optics 10, 10-1, 10-2, but it goes without saying that the present invention is not limited to this. A type of tracking mirror different from a type using electrostatic effect, which is a type of tracking mirror capable of controlling and changing the tilt of the angle of mirror by using a piezoelectric element, for example, may be used.
   Further, in the tracking mirror 100 (refer to Fig. 2), the reflection surface 116a was formed by gold (Au) coating, but it goes without saying that the present invention is not limited to this. The reflection surface 116a may be formed by dielectric multilayer film coating.
   Furthermore, the deformable mirror 200 (refer to Fig. 11 and Fig. 12) may be used as the adaptive optics 10, 10-1, 10-2 instead of the tracking mirror 100 (refer to Fig. 2) in the laser device of the above-described first to fourth embodiments, and the tracking mirror 100 may be used as the adaptive optics 10 instead of the deformable mirror 200 in the laser device of the fifth embodiment.
(5) In the above-described embodiments, a wavefront sensor may be further disposed in a predetermined position to take out a part of the laser beam that has been output from the resonator to take it into the wavefront sensor. Thus, the adaptive optics (10, 10-1, 10-2) can control not only the reflection angle of light to be reflected but also its wavefront, so that by controlling the adaptive optics (10, 10-1, 10-2) based on wavefront data measured by the wavefront sensor, it is possible to control the beam shape and the quality of an output laser beam simultaneously with the wavelength in real time by closed-loop control.
   In more detail, there has conventionally been a problem that the wavefront of output laser beam was disturbed due to the disturbance of wavefront of the laser medium or optical parts in the resonator each time when the laser beam transmits through them. Further, the laser medium serves as something like a lens in the resonator due to thermal lens effect when it is strongly excited, and there has been a problem that laser oscillation stopped, laser oscillation was weakened, or the shape of laser beam to be output is deformed due to the changes of excitation intensity or oscillation frequency.
   Then, when the wavefront sensor is disposed together with the adaptive optics 10, 10-1, 10-2 in the present invention, improvement of the beam shape of the output laser beam or fluctuation of phase wavefront is compensated to improve quality by changing the angles and the shapes of the mirrors of the adaptive optics 10, 10-1, 10-2 in response to the disturbance of wavefront so as to correct it, and the above-described conventional problems can be also solved. For example, the beam pattern of the output laser beam can be controlled in various beam patterns such as a beam pattern having excellent focusing property, which is referred to as a TEMOO mode.
   In the case of the deformable mirror 200 (refer to Fig. 11 and Fig. 12) that has been used as the adaptive optics 10 in the above-described fifth embodiment, the reflection surface 216a of the mirror 216 is formed of dielectric multilayer film coating, so that a damage threshold value becomes higher than that of a mirror having a reflection surface formed of metal coating, and it can deal with wavefront correction of a high output laser.
(6) In the above-described embodiments, various members can be additionally disposed in the laser resonator or the like, and an aperture for shaping a beam pattern or an etalon for controlling a spectrum width may be disposed, for example.
(7) The above-described embodiments and the modification examples shown in the above-described (1) to (6) may be combined appropriately.

### Industrial Applicability

Since the present invention is comprised as described above, a stable wavelength selecting action can be realized by controlling a laser wavelength to permit a fast wavelength sweeping without mechanically turning a heavy-mass member.

## Claims

1. A laser device, comprising:
a laser resonator made up of a mirror having predetermined transparency and an adaptive optics;
a laser medium disposed inside said laser resonator; and
a dispersion element for receiving an output light from said laser medium.

2. A laser device, comprising:
a laser medium capable of performing laser oscillation in a predetermined range of a wavelength band, which is disposed inside a laser resonator;
an adaptive optics having a mirror for receiving an output light from said laser medium;
a grating for receiving a light reflected by said mirror of said adaptive optics; and
a mirror having a predetermined transparency, which is disposed for receiving a diffraction light from said grading after the light is reflected by said mirror of said adaptive optics.

3. A laser device, comprising:
a laser medium capable of performing laser oscillation in a predetermined range of a wavelength band, which is disposed inside a laser resonator;
a grating for receiving an output light from said laser medium;
an adaptive optics having a mirror for receiving a diffraction light from said grating; and
a mirror having a predetermined transparency, which is disposed for receiving a light reflected by said mirror of said adaptive optics after the light is diffracted by said grating.

4. A laser device, comprising:
a laser medium capable of performing laser oscillation in a predetermined range of a wavelength band, which is disposed inside a laser resonator;
a prism for receiving an output light from said laser medium;
an adaptive optics having a mirror for receiving a light that has been dispersed by the prism; and
a mirror having a predetermined transparency, which is disposed for receiving a light reflected by said mirror of said adaptive optics.

5. A laser device, comprising:
a laser medium capable of performing laser oscillation in a predetermined range of a wavelength band, which is disposed inside a laser resonator;
a first adaptive optics having a mirror for receiving an output light from said laser medium;
a birefringent filter for receiving a light reflected by the mirror of said first adaptive optics;
a second adaptive optics having a mirror for receiving a light transmitted through said birefringent filter; and
a mirror having a predetermined transparency, which is disposed for receiving a light reflected by said mirror of said second adaptive optics.

6. A laser device, comprising:
a laser diode chip where reflection on one end surface is prevented and total reflection on the other end surface is permitted;
a grating for receiving an output light from said one end surface of said laser diode chip; and
an adaptive optics having a mirror for receiving the diffraction light from said grating.

7. A laser device according to any one of Claim 1, Claim 2, Claim 3, Claim 4, Claim 6 and Claim 6, wherein
said adaptive optics is any one of a tracking mirror and a deformable mirror.

8. A wavelength selecting method of a laser device, wherein
an output light from a laser medium capable of performing laser oscillation in a predetermined range of a wavelength band is reflected on the mirror of said adaptive optics to make the light incident to a grating such that a first-order diffraction light having a predetermined wavelength from said grating is made incident to the mirror of said adaptive optics, and
a light having a wavelength, which has been diffracted by said grating and made incident to the mirror of said adaptive optics, is allowed to reciprocate within a laser resonator to generate laser oscillation and is output.

9. A wavelength selecting method of a laser device, wherein
an output light from a laser medium capable of performing laser oscillation in a predetermined range of a wavelength band is made incident to a grating, a first-order diffraction light having a predetermined wavelength, which has been diffracted by the grating, is made incident perpendicularly to the mirror of an adaptive optics, and
a light having a wavelength, which has been made incident perpendicularly to the mirror of said adaptive optics and reflected, is allowed to reciprocate within a laser resonator to generate laser oscillation and is output as a 0-th order light from said grating.

10. A wavelength selecting method of a laser device, wherein
an output light from a laser medium capable of performing laser oscillation in a predetermined range of a wavelength band is made incident to a prism to disperse the light, a light having a predetermined wavelength, which has been dispersed by the prism, is made incident perpendicularly to the mirror of an adaptive optics, and
a light having a wavelength, which has been made incident perpendicularly to the mirror of said adaptive optics and reflected, is allowed to reciprocate within a laser resonator to generate laser oscillation and is output.

11. A wavelength selecting method of a laser device, wherein
an output light from a laser medium capable of performing laser oscillation in a predetermined range of a wavelength band is reflected on the mirror of a first adaptive optics and made incident to a birefringent filter, a light having transmitted through said birefringent filter is made incident to the mirror of a second adaptive optics, and
a light having a wavelength, which has been made incident to the mirror of said second adaptive optics and reflected, is allowed to reciprocate within a laser resonator to generate laser oscillation and is output.

12. A wavelength selecting method of a laser device, wherein
an output light from a laser diode chip is made incident to a grating, a first-order diffraction light having a predetermined wavelength, which has been diffracted by said grating, is made incident perpendicularly to the mirror of an adaptive optics, and
a light having a wavelength, which has been made incident perpendicularly to the mirror of said adaptive optics and reflected, is allowed to be output as a 0-th order light of said grating.

13. The wavelength selecting method of a laser device according to any one of Claim 8, Claim 9, Claim 10, Claim 11 and Claim 12, wherein
said adaptive optics is any one of a tracking mirror and a deformable mirror.
